(19) Europäisches Patentamt / European Patent Office / Office européen des brevets

(11) **EP 4 682 118 A1**

(12) **EUROPEAN PATENT APPLICATION**
published in accordance with Art. 153(4) EPC

(43) Date of publication:
**21.01.2026 Bulletin 2026/04**

(21) Application number: **24770736.7**

(22) Date of filing: **07.03.2024**

(51) International Patent Classification (IPC):
**C03B 8/04** [(2006.01)]

(52) Cooperative Patent Classification (CPC):
**C03B 19/106**

(86) International application number:
**PCT/JP2024/008902**

(87) International publication number:
**WO 2024/190630 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.03.2023 JP 2023041356**

(71) Applicant: **AGC INC.**
**Chiyoda-ku,**
**Tokyo 1008405 (JP)**

(72) Inventors:
• **SASAKI Kazuya**
  **Koriyama-shi, Fukushima 963-0215 (JP)**
• **TANAKA Koki**
  **Tokyo 100-8405 (JP)**

(74) Representative: **Müller-Boré & Partner**
**Patentanwälte PartG mbB**
**Friedenheimer Brücke 21**
**80639 München (DE)**

(54) **SILICA GLASS POROUS BODY AND MANUFACTURING METHOD THEREFOR**

(57) The present invention relates to a silica glass porous body having a plurality of pores, wherein: the pores include open pores; the bulk density of the silica glass porous body is 1.1 g/cm$^3$ to 1.7 g/cm$^3$; and the average pore size of the open pores as determined by mercury porosimetry is 50-200 $\mu$m.

*FIG. 2*

EP 4 682 118 A1

**Description**

TECHNICAL FIELD

The present invention relates to a silica glass porous body and a method for producing a silica glass porous body.

BACKGROUND ART

A silica glass porous body includes a plurality of pores, and is thus a material expected to be used for various applications such as a shower plate when a source gas is supplied in an etching step, a chemical vapor deposition step, or the like in a semiconductor device manufacturing process.
The silica glass porous body includes open pores that open onto any one surface. In particular, when the open pores include communication pores in which pores communicate with each other, in addition to a high purity property of synthetic silica, various properties such as a fluid permeating property and a light transmitting property can be provided by the communicating the open pores.
Patent Literature 1 describes a silica glass porous body having a specific average pore diameter.

CITATION LIST

PATENT LITERATURE

Patent Literature 1: WO 2022/215662

SUMMARY OF INVENTION

TECHNICAL PROBLEM

The silica glass porous body described in Patent Literature 1 has room for improvement in terms of the fluid permeating property and the light transmitting property.
An object of the present invention is to provide a novel silica glass porous body having an excellent fluid permeating property and light transmitting property.

SOLUTION TO PROBLEM

The present invention relates to the following silica glass porous body.
A silica glass porous body includes a plurality of pores,

in which the pores include open pores,
the silica glass porous body has a bulk density of 1.1 $g/cm^3$ to 1.7 $g/cm^3$, and
the open pores have an average pore diameter of 50 $\mu$m to 200 $\mu$m, as determined by mercury intrusion porosimetry.

The present invention also relates to the following method for producing a silica glass porous body.
A method for producing a silica glass porous body having a plurality of pores includes:

performing a heat treatment under conditions of a pressure of 0.01 MPa to 200 MPa, an inert gas atmosphere, and a temperature of 1200°C to 1700°C to obtain a silica glass dense body;
performing a foaming heat treatment under conditions of a pressure of 0 MPa to 0.4 MPa and a temperature of 1300°C to 1800°C to obtain a silica glass foamed body; and
subjecting the silica glass foamed body to a sintering heat treatment under conditions of a pressure of 0 MPa to 0.1 MPa and a temperature of 1350°C to 1550°C,
in which the temperature in the foaming heat treatment is at least 300°C higher than the temperature in the heat treatment during production of the silica glass dense body.

ADVANTAGEOUS EFFECTS OF INVENTION

According to the present invention, it is possible to provide a novel silica glass porous body having an excellent fluid permeating property and light transmitting property.

BRIEF DESCRIPTION OF DRAWINGS

[FIG. 1] FIG. 1 is a perspective view of a member obtained by cutting any part of a silica glass porous body according to one embodiment into a rectangular parallelepiped shape.
[FIG. 2] FIG. 2 is a cross-sectional view taken along a line X-X' in FIG. 1.
[FIG. 3] FIG. 3 is a flowchart showing a method for producing a silica glass porous body according to one embodiment.

DESCRIPTION OF EMBODIMENTS

Hereinafter, an embodiment according to the present invention (hereinafter, simply referred to as the present embodiment) is described in detail with reference to drawings. In the drawings, positional relationships such as up, down, left, and right are based on positional relationships shown in the drawings unless otherwise specified. Note that, dimensional ratios in the drawings are not limited to shown ratios. In addition, in the description, the term "to" used to express a numerical range includes numerical values before and after the term as a lower limit value and an upper limit value of the range, respectively. The lower limit value and the upper limit value include a rounding range.

<Silica Glass Porous Body>

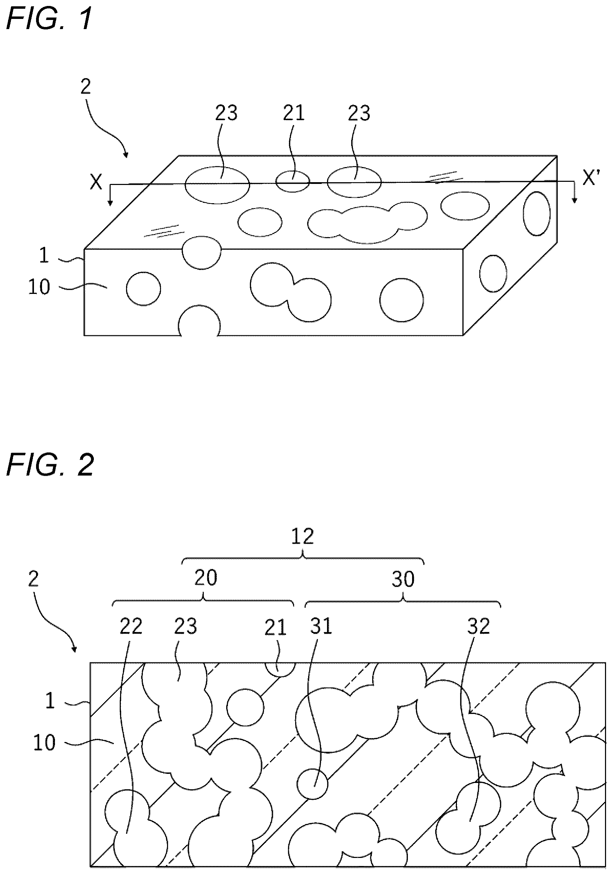

Structures of a silica glass porous body 1 and a silica glass porous body member 2 according to the present embodiment are described with reference to FIGS. 1 and 2.
FIG. 1 shows a perspective view of the member 2 obtained by cutting any part of the silica glass porous body 1 into a rectangular parallelepiped shape. FIG. 2 is a cross-sectional view taken along a line X-X' in FIG. 1.
The silica glass porous body 1 includes a silica glass portion 10 and pores 12.
The silica glass portion 10 contains amorphous silicon oxide ($SiO_2$) as a main component, and is transparent.
The pores 12 include open pores 20 and closed pores 30. The open pore is a pore having an opening exposed on at least any one surface. The closed pore is a pore that is not exposed, and contains a gas therein.
Since the silica glass porous body member according to the embodiment of the present invention has open pores, a fluid permeating property and a light transmitting property can be improved.
In the silica glass porous body, adjacent pores may communicate with each other. A non-communication pore has a substantially spherical shape. A communication pore has a shape formed by connecting substantially circular shapes. The pores may penetrate from any one surface to another surface of the silica glass porous body member. The penetrating pore may be a communication pore or a non-communication pore. Even in the case of a communication pore, it may not penetrate the member, and for example, in the case of one large pore, it may penetrate the member even when it is a non-communication pore.
In view of this aspect, as shown in FIG. 2, the open pores 20 are classified into a non-penetrating non-communication pore 21, a non-penetrating communication pore 22, a penetrating communication pore 23, and a penetrating non-communication pore (not shown). The closed pores 30 are classified into a non-penetrating non-communication pore 31 and a non-penetrating communication pore 32.
The non-penetrating non-communication pore 21 is formed by a non-communication pore that does not penetrate the member. The non-penetrating communication pore 22 is formed by a communication pore that does not penetrate the member. The penetrating communication pore 23 is formed by a communication pore that penetrates from any one surface to the other surface of the member 2. An appearance of the penetrating communication pore 23 in the surface of the member 2 has a shape formed by connecting substantially circular shapes.
In FIG. 2, the communication pore is shown in the form of two-dimensional communication, but it is natural that three-dimensional communication may occur.
Among the open pores, the presence of a communication pore is preferred, and the presence of a penetrating communication pore is particularly preferred, since the fluid permeating property and the light transmitting property can be improved.
Next, properties of the silica glass porous body according to the present embodiment are described.
The silica glass porous body has a bulk density of 1.1 g/cm³ to 1.7 g/cm³. When the bulk density is in such a range, strength of the silica glass porous body can be sufficiently obtained, and pores can be sufficiently contained.
The bulk density is preferably 1.2 g/cm³ or more, more preferably 1.3 g/cm³ or more, and is preferably 1.6 g/cm³ or less, more preferably 1.5 g/cm³ or less.
The open pores have an average pore diameter of 50 μm to 200 μm. When the average pore diameter of the open pores is 50 μm or more, the non-penetrating communication pore and the penetrating communication pore among the open pores are likely to be formed, and since the penetrating communication pore is likely to be formed, the fluid permeating property and the light transmitting property can be improved. In addition, even in the case where a protective film or the like is applied to a surface of a member produced using the silica glass porous body, it is possible to prevent scratches on an article that is held in contact with the member while maintaining the fluid permeating property and the light transmitting property without blocking the open pores. When the average pore diameter of the open pores is 200 $\mu$m or less, it is possible to reduce a distribution of the fluid permeating property and the light transmitting property due to a variation in pore diameter on the surface of the silica glass porous body. In addition, since it is possible to prevent the occurrence of breakage due to stress concentration at a specific portion of the silica glass, mechanical strength can be improved.

As described above, the silica glass porous body according to the present embodiment has a high bulk density and sufficiently high mechanical strength. Here, when the bulk density is high, in general, pores tend to be blocked during sintering or the pore diameter tends to be small. In addition, when the pore diameter is increased in order to improve the fluid permeating property or the like, the bulk density tends to decrease and the mechanical strength tends to be difficult to obtain. The silica glass porous body according to the present embodiment can achieve both a high bulk density and a high average pore diameter of open pores by controlling a pressure, a temperature, and a time in a high-temperature heat treatment, a foaming heat treatment, and a sintering heat treatment by a production method to be described later.

The average pore diameter of the open pores is preferably 70 $\mu$m or more, more preferably 100 $\mu$m or more, and is preferably 170 $\mu$m or less, more preferably 130 $\mu$m or less.

The average pore diameter of the open pores can be obtained by mercury intrusion porosimetry.

In the silica glass porous body, a proportion of a total volume of the open pores to a total volume of the pores (hereinafter also referred to as the "proportion of the open pores") is preferably 80% or more. When the proportion of the open pores is 80% or more, a proportion of the penetrating communication pore 23 formed by a communication pore that penetrates the member can be increased. The penetrating communication pore 23 easily permeates a liquid or a gas, and easily transmits light. Therefore, a higher proportion is preferred since the fluid permeating property of the silica glass porous body is improved. The proportion of the open pores is more preferably 85% or more.

The total volume of the pores is determined by subtracting a volume of the silica glass portion, which is determined from a sample weight, from an apparent volume of the sample. Alternatively, the volume of the pore portion may be measured using X-ray CT.

The total volume of the open pores is determined by mercury intrusion porosimetry.

The silica glass porous body preferably has a gas permeability coefficient of 0.2 $\mu$m$^2$ to 15 $\mu$m$^2$. When the gas permeability coefficient is in such a range, a sufficient fluid permeating property can be obtained.

The gas permeability coefficient is more preferably 0.5 $\mu$m$^2$ or more, still more preferably 1.0 $\mu$m$^2$ or more, and is more preferably 10 $\mu$m$^2$ or less, still more preferably 5 $\mu$m$^2$ or less.

The gas permeability coefficient of the silica glass porous body can be obtained by using a permporometer.

The silica glass porous body preferably has a total light transmittance of 30% to 60% at a thickness of 1.5 mm. When the total light transmittance is in such a range, a loss due to reflection is small, transmitted light can be efficiently used, and the transmitted light can be uniformly radiated by diffusion of the transmitted light.

The total light transmittance is more preferably 35% or more, still more preferably 40% or more, and is more preferably 55% or less, still more preferably 50% or less.

The total light transmittance of the silica glass porous body is determined using a spectrophotometer, and an average transmittance of light having a wavelength of 400 nm to 800 nm is defined as the total light transmittance in the present description.

The silica glass portion of the silica glass porous body contains amorphous silicon oxide ($SiO_2$) as a main component and has a density of approximately 2.2 g/cm$^3$. The silica glass portion may contain different elements in addition to $SiO_2$ for the purpose of controlling properties of the silica glass portion.

Examples of the different elements that may be contained in the silica glass portion include lithium (Li), sodium (Na), magnesium (Mg), aluminum (Al), potassium (K), calcium (Ca), chromium (Cr), manganese (Mn), iron (Fe), nickel (Ni), copper (Cu), titanium (Ti), cobalt (Co), zinc (Zn), silver (Ag), cadmium (Cd), and lead (Pb). A content of each metal impurity is 0.5 ppm by mass or less, and preferably 0.1 ppm by mass or less. When the content of each metal impurity is 0.5 ppm by mass or less, the member can be suitably used as a member used in a semiconductor manufacturing apparatus. In the description, ppm means parts per million and ppb means parts per billion.

<Production Method>

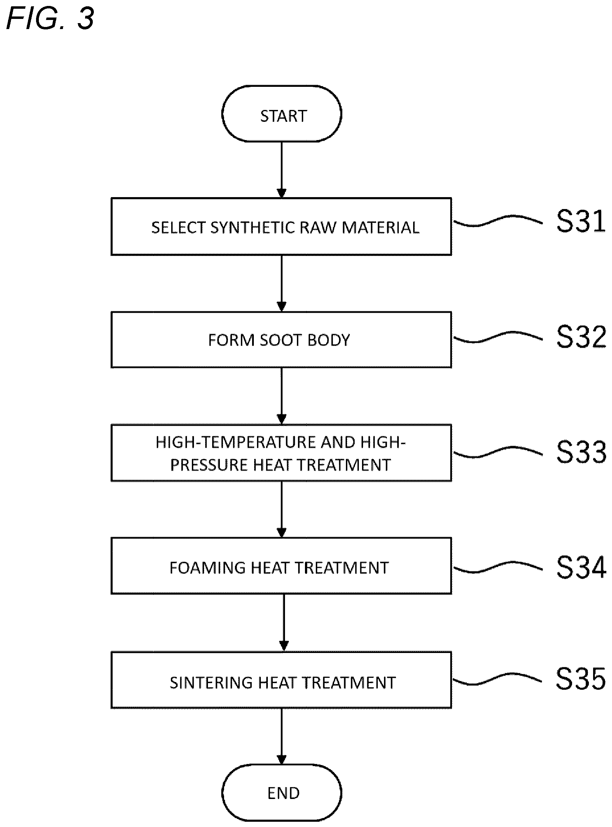

Next, a method for producing the silica glass porous body according to the present embodiment is described with reference to FIG. 3.

In the present embodiment, a vapor-phase axial deposition (VAD) method is used as a method for synthesizing a silica glass, but the production method may be changed as appropriate as long as effects of the present invention are exhibited.

As shown in FIG. 3, the method for producing a silica glass porous body preferably includes steps S31 to S35.

In the step S31, a synthetic raw material for the silica glass is selected. The synthetic raw material for the silica glass is not particularly limited as long as it is a gasifiable silicon-containing raw material, and examples thereof typically include halogen-containing silicon compounds such as silicon chlorides (for example, $SiCl_4$, $SiHCl_3$, $SiH_2Cl_2$, and $SiCH_3Cl_3$) and silicon fluorides (for example, $SiF_4$, $SiHF_3$, and $SiH_2F_2$), and halogen-free silicon compounds such as an alkoxysilane represented by $RnSi(OR)_{4-n}$ (R: an alkyl group having 1 to 4 carbon atoms, n: an integer of 0 to 3) and $(CH_3)_3Si\text{-}O\text{-}Si(CH_3)_3$.

Next, in the step S32, the synthetic raw material is subjected to flame hydrolysis at a temperature of preferably 1000°C to 1500°C to generate silica particles, and the generated silica particles are sprayed and deposited on a rotating base material to obtain a soot body. In the soot body, the silica particles are partly sintered together.

Although not shown, for the purpose of controlling electrical properties, the soot body may be subjected to a heat treatment under a vacuum atmosphere to dehydrate, to thereby reducing an OH group concentration. In this case, the temperature during the heat treatment is preferably 1000°C to 1300°C, and the treatment time is preferably 1 hour to 240 hours.

Next, in the step S33, the soot body is subjected to a heat treatment under high-temperature and high-pressure conditions in an inert gas atmosphere, whereby sintering of the silica particles in the soot body progresses and densification progresses to obtain a silica glass dense body. The silica glass dense body is a transparent silica glass substantially free of pores or an opaque silica glass having minute pores. At this time, during the heat treatment under high-temperature and high-pressure conditions, the temperature is preferably 1200°C to 1700°C, the pressure is preferably 0.01 MPa to 200 MPa, and the treatment time is preferably 1 hour to 100 hours.

In the step S33, the above inert gas is dissolved in the silica glass. The inert gas is typically helium (He), neon (Ne), argon (Ar), krypton (Kr), xenon (Xe), nitrogen gas ($N_2$), or a mixed gas containing at least two or more of these, and is preferably Ar, although details are to be described later. It is generally known that solubility of the inert gas in the silica glass tends to decrease as a partial pressure of the inert gas in the atmosphere decreases or as the temperature of the silica glass increases.

Next, in the step S34, the silica glass dense body is subjected to a foaming heat treatment. In this step, the inert gas dissolved in the silica glass is in a supersaturated state to precipitate bubbles of the inert gas in the silica glass, and thermal expansion causes foaming to reduce the bulk density, thereby obtaining a silica glass foamed body having pores. At this time, during the foaming heat treatment, the temperature is 1300°C to 1800°C, the pressure is 0 MPa to 0.4 MPa, and the treatment time is preferably 1 minute to 50 hours.

Here, a foaming mechanism is described. As described above, the solubility of the inert gas in the silica glass tends to decrease as the partial pressure of the inert gas in the atmosphere decreases or as the temperature of the silica glass increases. Therefore, in the step S34, when the treatment is performed at a lower pressure or a higher temperature than that in the step S33, the dissolved amount of the inert gas may be in a supersaturated state, and at this time, foaming occurs in the silica glass. The inert gas trapped in the pores by a densification heat treatment is thermally expanded by the heat treatment, and when the pressure in the pores is increased to be higher than the pressure in the heat treatment atmosphere, the silica glass whose viscosity is decreased by the heat treatment is deformed, and foaming occurs.

In consideration of the above mechanism, foaming may occur even when the temperature during the foaming heat treatment in the step S34 is lower than the temperature during the heat treatment in the step S33, but it is preferable that the temperature is higher than the temperature during the heat treatment in the step S33 since foaming is promoted. Therefore, the temperature during the foaming heat treatment is higher than the temperature during the heat treatment by 300°C or more.

The pressure during the foaming heat treatment in the step S34 is preferably lower than the pressure during the heat treatment in the step S33, and more preferably lower by 0.1 MPa or more.

Among the options for the inert gas described above, Ar is preferred from the viewpoint that Ar is relatively inexpensive, the solubility in the silica glass is highly dependent on the temperature, and the porosification is easily controlled.

Next, in the step S35, the silica glass foamed body is subjected to a sintering heat treatment. Through this step, the pores expand to communicate with each other, and further communicate with the surface to form open pores. When the heat treatment is continued in an open pore state, the sintering proceeds, the bulk density increases while maintaining the open pore state, and a silica glass porous body having both a high bulk density and a high open pore diameter is obtained. At this time, the heat treatment temperature is preferably 1350°C to 1550°C, the pressure is preferably 0 MPa to 0.1 MPa, and the treatment time is preferably 1 minute to 30 hours. The treatment time is preferably within 30 hours since there is no risk that the pores are blocked due to excessive heating. From the viewpoint of preventing blocking of the pores due to excessive heating, the temperature during the sintering heat treatment is preferably lower than that during the foaming heat treatment, and more preferably lower by 200°C or more. Further, the sintering heat treatment is more preferably performed under a vacuum from the viewpoint of preventing the formation of closed pores due to the entrapment of atmospheric gas during sintering.

The number of pores contained in the silica glass porous body, the pore diameter, the bulk density, and the like thereof can be controlled by appropriately adjusting the temperature, the pressure, and the treatment time in the high-temperature and high-pressure heat treatment in the step S33, the foaming heat treatment in the step S34, and the sintering heat treatment in the step S35 to change a foaming amount and a degree of expansion of the pores. For example, when the temperature is increased in the foaming heat treatment in step 34, the viscosity of the silica glass is lowered and the silica glass is easily deformed, and the pore diameter tends to increase. In addition, as the heat treatment time is longer, the pores collide with each other due to convection of the foamed pores, and partition walls are broken and coalesced, so that the pore diameter tends to increase. When the sintering heat treatment in the step S35 is performed at a higher temperature or for a longer heat treatment time, the sintering further proceeds, and a silica glass porous body having a higher bulk density is obtained.

<Fluid Permeating Member>

The silica glass porous body according to the present embodiment has an excellent fluid permeating property with respect to a liquid or a gas. Therefore, the silica glass porous body or the silica glass substrate made of the silica glass porous body according to the present embodiment is useful for various applications, for example, useful as a fluid permeating member. The fluid permeating member according to the present embodiment can be used, for example, as a shower plate member when a source gas is supplied in an etching step, a chemical vapor deposition step, or the like in a semiconductor manufacturing process.

<Light Transmitting Member>

The silica glass porous body according to the present embodiment is useful as a light transmitting member because of having an excellent light transmitting property. The light transmitting member according to the present embodiment can be used, for example, as a stage member for a semiconductor manufacturing apparatus. In the semiconductor manufacturing, an inspection for maintaining reliability of a semiconductor wafer is performed in each step. For example, a method of detecting a defect by processing an image captured by irradiating a wafer to be inspected with light is known, and a light transmitting material is used as a stage member on which the wafer is to be placed. It is preferable that the light transmitting material transmits light radiated to the wafer while diffusing the light. Therefore, the silica glass porous body according to the present embodiment described above is useful as a stage member for a semiconductor manufacturing apparatus because of preferably having a total light transmittance of 30% to 60% at a thickness of 1.5 mm.

When the silica glass porous body according to the present embodiment is used as a fluid permeating member or a light transmitting member, such a member may include a protective film on at least one main surface from the viewpoint of protecting the member surface and improving durability. That is, the present invention relates to a protective film-attached fluid permeating member including a fluid permeating member made of the silica glass porous body according to the present embodiment and a protective film formed on at least one main surface of the fluid permeating member. In addition, the present invention also relates to a protective film-attached light transmitting member including a light transmitting member made of the silica glass porous body according to the present embodiment and a protective film formed on at least one main surface of the light transmitting member.

As a method for forming the protective film, a known method described in WO 2016/051921 or the like can be used, and fluororesin coating is preferred. For example, a protective film made of a fluororesin layer can be formed by applying a powder or a dispersion liquid of a fluororesin to the surface of the silica glass porous body, followed by baking at preferably 280°C to 380°C for preferably 0.1 hour to 2 hours. As the fluororesin, at least one selected from PTFE (poly tetra fluoro ethylene; tetrafluoroethylene), PFA (tetra fluoro ethylene-perfluoro alkylvinyl ether copolymer), and FEP (fluorinated ethylene propylene copolymer; tetrafluoroethylene-hexafluoropropylene copolymer), or a copolymer having a basic structure of the above can be used.

The fluororesin is preferably particulate from the viewpoint of maintaining the fluid permeating property and light transmitting property of the silica glass porous body. Further, it is more preferable that the particle diameter of fluororesin particles is larger than the average pore diameter of the open pores of the silica glass porous body. Accordingly, the fluororesin particles can be prevented from entering the pores of the silica glass porous body, and the fluid permeating property and the light transmitting property of the silica glass porous body are easily maintained.

A thickness of the protective film is preferably 10 $\mu$m to 200 $\mu$m, more preferably 10 $\mu$m to 100 $\mu$m, particularly preferably 10 $\mu$m to 50 $\mu$m, and most preferably 10 $\mu$m to 30 $\mu$m, from the viewpoint of preventing scratches on the wafer caused by friction with the wafer placed on the silica glass member while maintaining the light transmitting property and the fluid permeating property.

As described above, the present description discloses the following silica glass porous body and production method.

[1] A silica glass porous body including a plurality of pores,

in which the pores include open pores,
the silica glass porous body has a bulk density of 1.1 g/cm$^3$ to 1.7 g/cm$^3$, and
the open pores have an average pore diameter of 50 $\mu$m to 200 $\mu$m, as determined by mercury intrusion porosimetry.

[2] The silica glass porous body according to [1], in which the pores include communication pores.

[3] The silica glass porous body according to [1] or [2], in which a proportion of a total volume of the open pores to a total volume of the pores is 80% or more.

[4] The silica glass porous body according to any one of [1] to [3], in which the silica glass porous body has a gas permeability coefficient of 0.2 $\mu$m$^2$ to 15 $\mu$m$^2$.

[5] The silica glass porous body according to any one of [1] to [4], in which the silica glass porous body has a total light transmittance of 30% to 60% at a thickness of 1.5 mm.

[6] A light transmitting member including the silica glass porous body according to any one of [1] to [5].

[7] A protective film-attached light transmitting member including:

a light transmitting member including the silica glass porous body according to any one of [1] to [5]; and
a protective film having a thickness of 10 $\mu$m to 200 $\mu$m formed on at least one main surface of the light transmitting member.

[8] A stage member for a semiconductor manufacturing apparatus, including the light transmitting member according to [6].

[9] A stage member for a semiconductor manufacturing apparatus, including the protective film-attached light transmitting member according to [7].

[10] A method for producing a silica glass porous body including a plurality of pores, the method including:

performing a heat treatment under conditions of a pressure of 0.01 MPa to 200 MPa, an inert gas atmosphere, and a temperature of 1200°C to 1700°C to obtain a silica glass dense body;
performing a foaming heat treatment under conditions of a pressure of 0 MPa to 0.4 MPa and a temperature of 1300°C to 1800°C to obtain a silica glass foamed body ; and
subjecting the silica glass foamed body to a sintering heat treatment under conditions of a pressure of 0 MPa to 0.1 MPa and a temperature of 1350°C to 1550°C,
in which the temperature in the foaming heat treatment is at least 300°C higher than the temperature in the heat treatment during production of the silica glass dense body.

[11] The production method according to [10], in which the temperature in the sintering heat treatment is lower than the temperature in the foaming heat treatment.

[12] The production method according to [10] or [11], in which the sintering heat treatment is performed under a vacuum.

[13] The production method according to any one of [10] to [12],

in which the pores in the silica glass porous body include open pores,
the silica glass porous body has a bulk density of 1.1 g/cm$^3$ to 1.7 g/cm$^3$, and
the open pores have an average pore diameter of 50 $\mu$m to 200 $\mu$m, as determined by mercury intrusion porosimetry.

EXAMPLES

Hereinafter, the present invention is described in more detail using Examples, but the present invention should not be construed as being limited to these Examples.

Examples 1 to 6 are Inventive Examples, and Examples 7 to 9 are Comparative Examples.

The bulk density was obtained by cutting the object to be evaluated into a cylindrical shape having a diameter of 10 mm and a thickness of 5 mm, measuring the sample mass by an electronic balance, and dividing the sample mass by the apparent volume of the sample.

The average pore diameter of the open pores was determined by mercury intrusion porosimetry in accordance with JIS-R1655:2003. Specifically, the object to be evaluated was cut into a cylindrical shape having a diameter of 10 mm and a thickness of 5 mm, a pore diameter distribution was measured using a mercury porosimeter (Auto Pore V9620 manufactured by Micromeritics Instrument Corporation), and the pore diameter when a cumulative pore volume was 50% of a total pore volume was defined as the average pore diameter.

The gas permeability coefficient was determined by using a permporometer. Specifically, the object to be evaluated was cut into a disk shape having a diameter of 25 mm and a thickness of 2 mm, set in a holder of the permporometer (CFP-1200AEXL manufactured by PMI), and the gas was circulated at a flow rate of 1 L/min to 200 L/min.

At this time, the gas permeability coefficient (K) when $\Delta P = 10$ kPa was determined according to the following equation (1). Air was used as the gas.

[Math. 1]

$$K = (\mu \cdot L \cdot Q)/(\Delta P \cdot A) \qquad \cdots (1)$$

In the above equation (1), K represents the gas permeability coefficient (unit: $m^2$), $\mu$ represents a gas viscosity (unit: Pa·s), L represents a sample thickness (unit: m), Q represents a gas flow rate ($m^3$/s), $\Delta P$ represents a pressure difference (unit: Pa) between a gas inlet portion and a gas outlet portion in the sample, and A represents a cross-sectional area of the sample ($m^2$).

The total light transmittance was determined using a spectrophotometer. Specifically, the object to be evaluated was cut to have a thickness of 1.5 mm, the total light transmittance at wavelengths of 400 nm to 800 nm was measured using a spectrophotometer (UH4150 manufactured by Hitachi High-Tech Corporation) using an integrating sphere, and the average value of the transmittance at each wavelength was used as the measured value.

(Examples 1 to 8)

Silicon tetrachloride ($SiCl_4$) was selected as the synthetic raw material for the silica glass, and was subjected to flame hydrolysis to generate silica particles. The generated silica particles were sprayed and deposited on a rotating base material to obtain a soot body.

Next, the soot body was placed in a heating furnace, and the heating furnace was filled with an Ar gas. The soot body was subjected to a high-temperature and high-pressure treatment and densified at the temperature, the pressure, and the treatment time shown in Table 1, followed by returning to an atmospheric pressure and allowing to cool. The silica glass dense body obtained at this time was an opaque silica glass having minute pores.

Next, a foaming heat treatment was performed at the temperature, the pressure, and the treatment time shown in Table 1 to make the silica glass dense body porous.

The porous silica glass foamed body was further evacuated, subjected to a sintering heat treatment at the temperature, the pressure, and the treatment time shown in Table 1 in a reduced pressure atmosphere, and then allowed to cool, and the obtained silica glass porous body was taken out.

(Example 9)

The soot body obtained in Example 1 was subjected to a heat treatment at 1250°C for 50 hours to obtain a silica glass porous body.

The silica glass porous body obtained in Example 6 was cut into each size dimension for evaluation, a dispersion liquid in which a PFA resin was dispersed in a coating liquid was applied to one main surface, and a heat treatment was performed at 320°C for 30 minutes to perform transparent fluororesin coating, thereby forming a protective film having a thickness of 30 $\mu$m.

The physical property values of each silica glass porous body obtained as described above are shown in Table 2.

[Table 1]

| | High-temperature and high-pressure treatment | | | | Foaming heat treatment | | | | Sintering heat treatment | | | |
|---|---|---|---|---|---|---|---|---|---|---|---|---|
| | Temperature (°C) | Time (hr) | Atmosphere | Pressure (MPa) | Temperature (°C) | Time (hr) | Atmosphere | Pressure (MPa) | Temperature (°C) | Time (hr) | Atmosphere | Pressure (MPa) |
| Example 1 | 1400 | 5 | Ar | 0.9 | 1750 | 2.5 | Ar | 0.1 | 1475 | 9 | Vacuum | 0 |
| Example 2 | 1400 | 5 | Ar | 0.9 | 1720 | 5 | Ar | 0.1 | 1475 | 13.5 | Vacuum | 0 |
| Example 3 | 1400 | 5 | Ar | 0.9 | 1720 | 2.5 | Ar | 0.1 | 1475 | 9 | Vacuum | 0 |
| Example 4 | 1400 | 5 | Ar | 0.9 | 1720 | 2.5 | Ar | 0.1 | 1475 | 13.5 | Vacuum | 0 |
| Example 5 | 1400 | 5 | Ar | 0.9 | 1720 | 2.5 | Ar | 0.1 | 1475 | 16 | Vacuum | 0 |
| Example 6 | 1400 | 5 | Ar | 0.9 | 1720 | 2.5 | Ar | 0.1 | 1475 | 9 | Vacuum | 0 |
| Example 7 | 1400 | 5 | Ar | 0.9 | 1680 | 2.5 | Ar | 0.1 | 1475 | 4.5 | Vacuum | 0 |
| Example 8 | 1400 | 5 | Ar | 0.9 | 1680 | 2.5 | Ar | 0.1 | 1475 | 9 | Vacuum | 0 |
| Example 9 | Subject soot body to heat treatment at 1250°C for 50 hours | | | | | | | | | | | |

[Table 2]

| | Bulk density (g/cm³) | Porosity (%) | Average pore diameter (μm) of open pores | Proportion of open pores | Gas permeability coefficient (μm²) | Total light transmittance (%) (at thickness of 1.5 mm) | Protective film |
|---|---|---|---|---|---|---|---|
| Example 1 | 1.11 | 49.4 | 161.7 | 85% | 9.9 | 44.5 | No |
| Example 2 | 1.27 | 42.3 | 128.4 | 89% | 3.1 | 50.0 | No |
| Example 3 | 1.20 | 45.6 | 71.1 | 89% | 1.8 | 44.2 | No |
| Example 4 | 1.39 | 36.8 | 73.0 | 90% | 0.6 | 38.4 | No |
| Example 5 | 1.55 | 29.5 | 58.4 | 86% | 0.26 | 48.3 | No |
| Example 6 | 1.20 | 45.6 | 71.1 | 89% | 1.7 (measured value with protective film) | 42.1 (measured value with protective film) | Yes (30 μm) |
| Example 7 | 1.30 | 40.9 | 40.0 | 79% | 0.15 | 37.7 | No |
| Example 8 | 1.61 | 27.0 | 21.7 | 71% | 0.06 | 47.5 | No |
| Example 9 | 1.26 | 42.8 | 0.32 | 100% | 0.01 | 0.52 | - |

From the above results, it can be seen that the silica glass porous bodies in Examples 1 to 6 having a bulk density of 1.1 g/cm³ to 1.7 g/cm³ and an average pore diameter of open pores of 50 μm to 200 μm had a good fluid permeating property due to a high gas permeability coefficient, and had a good light transmitting property due to a high total light transmittance.

The silica glass porous body in Example 6 was produced in the same manner as the silica glass porous body in Example 3 except that the protective film was provided on the surface, but the average pore diameter of the open pores was 50 μm to 200 μm, and thus the gas permeability coefficient and the total light transmittance were substantially the same as those in Example 3.

The silica glass porous bodies in Examples 7 to 9 in which the average pore diameter of the open pores was less than 50 μm particularly had a gas permeability coefficient lower than that in Examples 1 to 6.

Although the present invention has been described in detail with reference to specific embodiments, it is apparent to those skilled in the art that various changes and modifications can be made without departing from the spirit and scope of the present invention. The present application is based on a Japanese Patent Application (Japanese Patent Application No. 2023-041356) filed on March 15, 2023, the content of which is incorporated herein by reference.

INDUSTRIAL APPLICABILITY

Since the silica glass porous body according to the present embodiment has an excellent fluid permeating property and light transmitting property, it is useful as, for example, a stage member for a semiconductor device manufacturing apparatus required to have a gas permeating property and a light transmitting property.

REFERENCE SIGNS LIST

1 silica glass porous body

2 member
10 silica glass portion
12 pore
20 open pore
21 non-penetrating non-communication pore
22 non-penetrating communication pore
23 penetrating communication pore
30 closed pore
31 non-penetrating non-communication pore
32 non-penetrating communication pore

**Claims**

1. A silica glass porous body comprising a plurality of pores,

   wherein the pores comprise open pores,
   the silica glass porous body has a bulk density of 1.1 g/cm$^3$ to 1.7 g/cm$^3$, and
   the open pores have an average pore diameter of 50 $\mu$m to 200 $\mu$m, as determined by mercury intrusion porosimetry.

2. The silica glass porous body according to claim 1, wherein the pores comprise communication pores.

3. The silica glass porous body according to claim 1, wherein a proportion of a total volume of the open pores to a total volume of the pores is 80% or more.

4. The silica glass porous body according to claim 1, wherein the silica glass porous body has a gas permeability coefficient of 0.2 $\mu$m$^2$ to 15 $\mu$m$^2$.

5. The silica glass porous body according to claim 1, wherein the silica glass porous body has a total light transmittance of 30% to 60% at a thickness of 1.5 mm.

6. A light transmitting member comprising the silica glass porous body according to any one of claims 1 to 5.

7. A protective film-attached light transmitting member comprising:

   a light transmitting member comprising the silica glass porous body according to any one of claims 1 to 5; and
   a protective film having a thickness of 10 $\mu$m to 200 $\mu$m formed on at least one main surface of the light transmitting member.

8. A stage member for a semiconductor manufacturing apparatus, comprising the light transmitting member according to claim 6.

9. A stage member for a semiconductor manufacturing apparatus, comprising the protective film-attached light transmitting member according to claim 7.

10. A method for producing a silica glass porous body comprising a plurality of pores, the method comprising:

    performing a heat treatment under conditions of a pressure of 0.01 MPa to 200 MPa, an inert gas atmosphere, and a temperature of 1200°C to 1700°C to obtain a silica glass dense body;
    performing a foaming heat treatment under conditions of a pressure of 0 MPa to 0.4 MPa and a temperature of 1300°C to 1800°C to obtain a silica glass foamed body ; and
    subjecting the silica glass foamed body to a sintering heat treatment under conditions of a pressure of 0 MPa to 0.1 MPa and a temperature of 1350°C to 1550°C,
    wherein the temperature in the foaming heat treatment is at least 300°C higher than the temperature in the heat treatment during production of the silica glass dense body.

11. The production method according to claim 10, wherein the temperature in the sintering heat treatment is lower than the temperature in the foaming heat treatment.

**12.** The production method according to claim 10, wherein the sintering heat treatment is performed under a vacuum.

**13.** The production method according to claim 10,

wherein the pores in the silica glass porous body comprise open pores,
the silica glass porous body has a bulk density of 1.1 g/cm$^3$ to 1.7 g/cm$^3$, and
the open pores have an average pore diameter of 50 $\mu$m to 200 $\mu$m, as determined by mercury intrusion porosimetry.

*FIG. 1*

*FIG. 2*

*FIG. 3*

```
                    ┌──────────┐
                    │  START   │
                    └──────────┘
                         │
                         ▼
         ┌───────────────────────────────────┐
         │   SELECT SYNTHETIC RAW MATERIAL    │ ⟍  S31
         └───────────────────────────────────┘
                         │
                         ▼
         ┌───────────────────────────────────┐
         │          FORM SOOT BODY           │ ⟍  S32
         └───────────────────────────────────┘
                         │
                         ▼
         ┌───────────────────────────────────┐
         │   HIGH-TEMPERATURE AND HIGH-      │ ⟍  S33
         │   PRESSURE HEAT TREATMENT         │
         └───────────────────────────────────┘
                         │
                         ▼
         ┌───────────────────────────────────┐
         │      FOAMING HEAT TREATMENT       │ ⟍  S34
         └───────────────────────────────────┘
                         │
                         ▼
         ┌───────────────────────────────────┐
         │     SINTERING HEAT TREATMENT      │ ⟍  S35
         └───────────────────────────────────┘
                         │
                         ▼
                    ┌──────────┐
                    │   END    │
                    └──────────┘
```

## INTERNATIONAL SEARCH REPORT

| International application No. |
|---|
| **PCT/JP2024/008902** |

### A. CLASSIFICATION OF SUBJECT MATTER

*C03B 8/04*(2006.01)i
FI:  C03B8/04 A

According to International Patent Classification (IPC) or to both national classification and IPC

### B. FIELDS SEARCHED

Minimum documentation searched (classification system followed by classification symbols)

C03B8/04

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2022/215662 A1 (AGC INC.) 13 October 2022 (2022-10-13) | 1-13 |
| A | JP 9-30835 A (SHIN-ETSU QUARTZ PRODUCTS CO., LTD.) 04 February 1997 (1997-02-04) | 1-13 |
| A | JP 4-224135 A (ASAHI GLASS COMPANY, LIMITED) 13 August 1992 (1992-08-13) | 1-13 |

☐ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **08 May 2024** | **21 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/008902**

| Patent document cited in search report | | | Publication date (day/month/year) | Patent family member(s) | | | Publication date (day/month/year) |
|---|---|---|---|---|---|---|---|
| WO | 2022/215662 | A1 | 13 October 2022 | US | 2024/0025802 | A1 | |
| | | | | KR | 10-2023-0167357 | A | |
| | | | | CN | 117321012 | A | |
| JP | 9-30835 | A | 04 February 1997 | (Family: none) | | | |
| JP | 4-224135 | A | 13 August 1992 | (Family: none) | | | |

Form PCT/ISA/210 (patent family annex) (July 2022)

## EP 4 682 118 A1

### REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022215662 A
- WO 2016051921 A
- JP 2023041356 A